# EUROPEAN PATENT SPECIFICATION

(11) **EP 4 376 106 B1**
(45) Date of publication and mention of the grant of the patent: **21.10.2026**
(21) Application number: 24169949.5
(22) Date of filing: 11.02.2020
(51) Int. Cl.: H10H 20/84

(54) **ELECTRONIC DEVICE**
ELEKTRONISCHE VORRICHTUNG
DISPOSITIF ÉLECTRONIQUE

(30) Priority: 21.02.2019 US 201916282272
(43) Date of publication of application: 29.05.2024
(62) Document number(s) of the earlier application(s) in accordance with Art. 76 EPC: 22183296.7 / 4 089 747; 20156544.7 / 3 699 966
(73) Proprietor: InnoLux Corporation, Chu-Nan, Miao-Li 350 (TW)
(72) Inventor: Chen, Jia-Yuan, 350 Miao-Li County (TW); Tsai, Tsung-Han, 350 Miao-Li County (TW); Lee, Kuan-Feng, 350 Miao-Li County (TW); Wu, Yuan-Lin, 350 Miao-Li County (TW)
(74) Representative: Straus, Alexander

(56) References cited:
- EP-A1- 2 741 338
- EP-A1- 2 833 421
- EP-A1- 3 142 157
- EP-A2- 2 197 051
- EP-A2- 2 565 941
- US-A1- 2010 210 046

## Description

### Field of the Invention

The present invention relates to a lighting device having a light adjusting layer for making an emitting light uniform.

### Background of the Disclosure

EP 3142157 A1 discloses a light emitting device. The light emitting device includes: a light emitting structure including a first conductive semiconductor layer, an active layer disposed under the first conductive semiconductor layer, and a second conductive semiconductor layer disposed under the active layer; a protective layer disposed above the light emitting structure and including a through region; a first electrode disposed in the through region and electrically connected to the first conductive semiconductor layer; an electrode pad electrically connected to the first electrode, and having a first region disposed on the first electrode and a second region disposed on the protective layer; and a second electrode electrically connected to the second conductive semiconductor layer.

EP 2741338 A1 discloses a light emitting device. The light emitting device includes a substrate, light emitting cells, each of the light emitting cells including a light emitting structure including lower and upper semiconductor layers, an upper electrode, and a lower electrode, a conductive interconnection layer electrically connecting a lower electrode of a first one of the light emitting cells and an upper electrode of a second one of the light emitting cells, and a current blocking layer disposed to extend from between the upper electrode and the upper semiconductor layer, wherein each light emitting cell further includes a conductive layer arranged to electrically connect the upper electrode of the second light emitting cell to the upper semiconductor layer of the second light emitting cell.

EP 2833421 A1 discloses a semiconductor light emitting device. In the semiconductor light emitting device, the optical layer has a larger planar size than the semiconductor layer. The optical layer is transmissive to emission light of the light emitting layer. The first insulating film is provided on a side surface of the semiconductor layer continued from the first surface. The metal film includes a first reflective part covering the side surface of the semiconductor layer via the first insulating film. The metal film includes a second reflective part opposed to the optical layer in a region around the side surface of the semiconductor layer and extending from the first reflective part toward a side opposite from the side surface of the semiconductor layer.

As the evolution and development of electronic devices, the electronic devices are widely used and have become an indispensable item in these days. For example, a lighting device, which is a kind of the electronic devices, may have been used in any suitable electronic products with display function, such as televisions, monitor, notebooks, smart phones, watches, and display devices in vehicles, so as to transmit and display information more conveniently.

In general, the electronic device may have a light emitting unit, such as light-emitting diode (LED), to emit light. The edge region of one individual light emitting unit may be damaged due to the manufacturing process such as etching, thus resulting in excessive centralized or concentrated light. Furthermore, when the size of the light emitting unit is reduced for enhancing the resolution or decreasing the size of the electronic device, the damaged region will not be reduced. Therefore, the damaged region of the light emitting unit will have a high ratio, which makes the phenomenon of centralization of light more severe, thus resulting in non-uniform light and less light output.

### Summary of the Disclosure

This in mind, the present invention aims at providing a lighting device having a light adjusting layer for making an emitting light uniform.

This is achieved by a lighting device according to the independent claim. The dependent claims pertain to corresponding further developments and improvements.

The present invention provides a lighting device as defined in independent claim 1.

Owing to the design of the light adjusting layer, the light emitted from the lighting device can be uniform.

### Brief Description of the Drawings

In the following, the invention is further illustrated by way of example, taking reference to the accompanying drawings. Thereof
FIG. 1 is a schematic diagram showing a cross-sectional view of a lighting device according to a first example not forming part of the present invention,
FIG. 2 is a schematic diagram showing a top view of a light emitting unit and a light adjusting layer according to the first example,
FIG. 3 to FIG. 4 are schematic diagrams respectively showing a top view of the light emitting unit and the light adjusting layer of FIG. 1 according to variants of the first example not forming part of the present invention,
FIG. 5 to FIG. 8 are schematic diagrams respectively showing a top view of a light emitting unit and a light adjusting layer according to variants of the first example not forming part of the present invention,
FIG. 9 to FIG. 14 are schematic diagrams respectively showing a cross-sectional view of a processing state during a method for manufacturing the lighting device according to the first example,
FIG. 15 is a schematic diagram showing a cross-sectional view of a lighting device according to a second example not forming part of the present invention,
FIG. 16 is a schematic diagram showing a top view of light emitting units and a light adjusting layer according to the second example,
FIG. 17 is a schematic diagram showing a cross-sectional view of a lighting device according to a third example not forming part of the present invention,
FIG. 18 is a schematic diagram showing a top view of a lighting device according to a varian of the third example,
FIG. 19 is a schematic diagram showing a cross-sectional view of a lighting device according to a fourth example not forming part of the present invention,
FIG. 20 is a schematic diagram showing a top view of a light emitting unit and a light adjusting layer according to the fourth example,
FIG. 21 is a schematic diagram showing a cross-sectional view of a lighting device according to a fifth example not forming part of the present invention,
FIG. 22 is a schematic diagram showing a top view of a light emitting unit and a light adjusting layer according to the fifth example, and
FIG. 23 is a schematic diagram showing a top view of a light emitting unit and a light adjusting layer according to a variant the fifth example not forming part of the present invention.

### Detailed Description

The present invention may be understood by reference to the following detailed description, taken in conjunction with the drawings as described below. It is noted that, for purposes of illustrative clarity and being easily understood by the readers, various drawings of this disclosure show a portion of an electronic device, and certain elements in various drawings may not be drawn to scale. In addition, the number and dimension of each device shown in drawings are only illustrative and are not intended to limit the scope of the present invention.

Certain terms are used throughout the description and following claims to refer to particular components. As one skilled in the art will understand, electronic equipment manufacturers may refer to a component by different names. This document does not intend to distinguish between components that differ in name but not function. In the following description and in the claims, the terms "include", "comprise" and "have" are used in an open-ended fashion, and thus should be interpreted to mean "include, but not limited to...". Thus, when the terms "include", "comprise" and/or "have" are used in the description of the present disclosure, the corresponding features, areas, steps, operations and/or components would be pointed to existence, but not limited to the existence of one or a plurality of the corresponding features, areas, steps, operations and/or components. In the present disclosure, if not described by any adjective, the term "cover" can mean "partially cover" or "completely cover".

When the corresponding component such as layer or area is referred to "on another component (or the variant thereof)" or "extend to another component", it may be directly on another component or directly extend to another component, or other component may exist between them. On the other hand, when the component is referred to "directly on another component (or the variant thereof)" or "directly extend to another component", any component does not exist between them.

It will be understood that when an element or layer is referred to as being "on" or "connected to" another element or layer, it can be directly on or directly connected to the other element or layer, or intervening elements or layers may be presented. In contrast, when an element is referred to as being "directly on" or "directly connected to" another element or layer, there are no intervening elements or layers presented. In addition, when the component is referred to "be coupled to/with another component (or the variant thereof)", it may be directly connected to another component, or may be indirectly connected (such as electrically connected) to another component through other component or components.

It should be noted that the technical features in different examples described in the following can be replaced, recombined, or mixed with one another to constitute an embodiment without departing from the scope of the present invention as defined by the claims.

In the present invention, a lighting device is a suitable electronic device which can emit light. In some embodiments, the lighting device may be the electronic device with display function, such as a LED display, a micro LED display, a mini LED display, an OLED (organic light-emitting diode) display, a QLED (quantum dots light-emitting diode) display, a flexible display or other suitable self-luminous display. Or, in some embodiments, the lighting device may be a component of the electronic device with display function, such as a backlight module of the LC (liquid crystal) display.

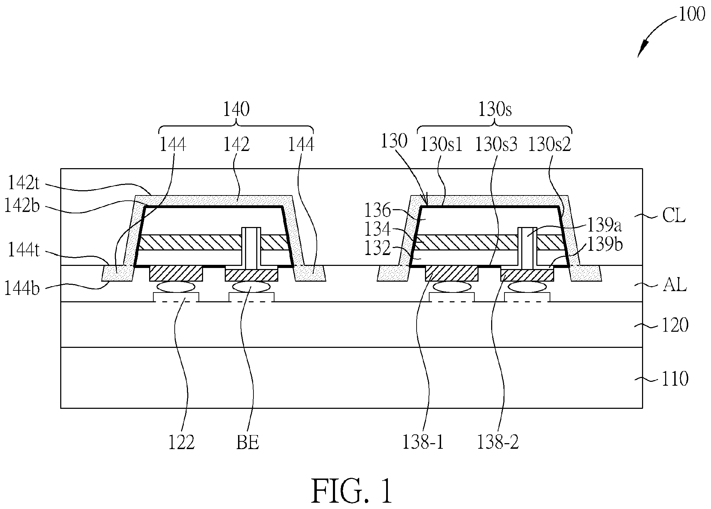

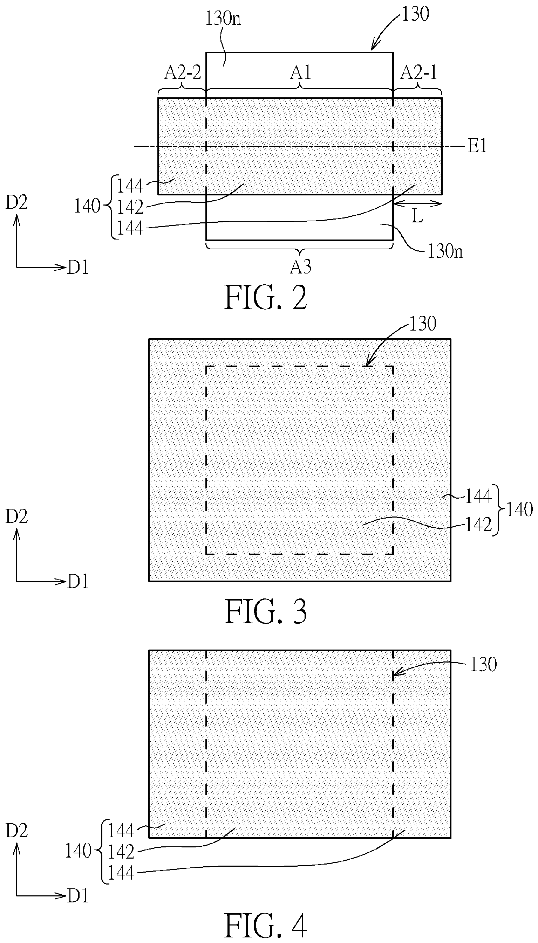

Referring to FIG. 1 and FIG. 2, FIG. 1 is a schematic diagram showing a cross-sectional view of a lighting device according to a first example not forming part of the present invention, and FIG. 2 is a schematic diagram showing a top view of a light emitting unit and a light adjusting layer according to the first example. As shown in FIG. 1 and FIG. 2, the lighting device 100 of this example includes a substrate 110, a circuit layer 120, one or more light emitting unit(s) 130 and a light adjusting layer 140. The substrate 110 may be a hard substrate such as a glass substrate, a plastic substrate, a quartz substrate, a sapphire substrate, a circuit board (e.g. printed circuit board) or other suitable hard substrate, or may be a flexible substrate including polyimide (PI), polyethylene terephthalate (PET) and/or other suitable flexible material, but not limited thereto. The type and material of the substrate 110 may be selected according to the application of the lighting device 100; for example, the substrate 110 may be a glass substrate if the lighting device 100 is served as a non-flexible micro LED display, and the substrate 110 may be a circuit board if the lighting device 100 is served as a backlight module, but not limited thereto.

According to this example, the circuit layer 120 is disposed on the substrate 110, a plurality of light emitting units 130 are disposed on the circuit layer 120, and the circuit layer 120 is configured to drive the light emitting units 130 for emitting light. In detail, the circuit layer 120 may include at least one conductive layer, at least one insulating layer and/or at least one semiconductor layer to form a plurality of electronic components, such as traces, thin film transistors, capacitor or other suitable components, and the light emitting units 130 are electrically connected to at least one of the electronic components respectively. The conductive layer may include metal, and/or transparent conductive material. The transparent conductive material can includes indium tin oxide (ITO), indium zinc oxide (IZO)) and/or other suitable conductive material. The material of each insulating layer may individually include silicon oxide, silicon nitride and/or silicon oxynitride. The material of each semiconductor layer may include low temperature poly-silicon (LTPS), indium gallium zinc oxide (IGZO) or amorphous silicon (a-Si), but the present disclosure is not limited thereto.

The circuit layer 120 may include at least one bonding pad 122 formed of the uppermost conductive layer, and one of the light emitting units 130 is electrically connected to the electronic components included in the circuit layer 120 through the bonding pad 122. In addition, the lighting device 100 of this example may further include an integrated circuit (not shown in figures) electrically connected to the electronic components included in the circuit layer 120 and the light emitting unit 130, such that the integrated circuit and the electronic components of the circuit layer 120 may drive the light emitting units 130 for emitting light, but not limited thereto. In another embodiment, the electronic components of the circuit layer 120 may form a driving circuit to drive the light emitting units 130.

One of the light emitting units 130 may be a LED, a micro LED, a mini LED, an OLED, a QLED or other suitable light emitting component. For example, if the lighting device 100 is served as a self-luminous display, the light emitting unit 130 may be a component disposed within a sub-pixel; if the lighting device 100 is served as a backlight module, the light emitting unit 130 may be a component providing backlight, but not limited thereto. In accordance with the present invention, as shown in FIG. 1, the light emitting unit 130 includes a first semiconductor layer 132, a light emitting layer 134 disposed on the first semiconductor layer 132, and a second semiconductor layer 136 disposed on the light emitting layer 134. For example, the first semiconductor layer 132 may be a p-type semiconductor layer, the second semiconductor layer 136 may be an n-type semiconductor layer, and the light emitting layer 134 is a multiple quantum well (MQW), but not limited thereto. Note that the light emitting unit 130 may include suitable material based on the type of LED and the color of the light. Moreover, the light emitting unit 130 includes a first electrode 138-1 and a second electrode 138-2. The first electrode 138-1 is electrically connected to the first semiconductor layer 132, and the second electrode 138-2 is electrically connected to the second semiconductor layer 136. In this embodiment, the light emitting unit 130 is flip-chip type, the first electrode 138-1 and the second electrode 138-2 are disposed on the same side of the light emitting unit 130, and each of the first electrode 138-1 and the second electrode 138-2 is electrically connected to one bonding pad 122 of the circuit layer 120 with bonding element BE respectively. The second electrode 138-2 is electrically connected to the second semiconductor layer 136 through an inner connecting component 139a, and the inner connecting component 139a is separated from the first semiconductor layer 132 by an inner insulator 139b, but the connection method is not limited thereto. Based on requirements, the positions of the first electrode 138-1 and the second electrode 138-2 may be adjusted. In addition, the material of the first electrode 138-1 and the second electrode 138-2 may be metal, but not limited thereto. Furthermore, the light emitting unit 130 may optionally include buffer layer or other suitable layer for instance.

In accordance with the present invention, the light emitting unit 130 includes a light output surface 130s (indicated as a bold line in FIG. 1), and the light output surface 130s is defined as a surface which the light emitted from the light emitting layer 134 may pass through. For example, in FIG. 1, when the first electrode 138-1 and the second electrode 138-2 include metal and can shield the light emitted from the light emitting layer 134, the surface that occupied by the first electrode 138-1 and the second electrode 138-2 does not belong to the light output surface 130s.

The edge region of one individual light emitting unit may be damaged due to the manufacturing process such as etching, thus resulting in excessive centralized or concentrated light. Furthermore, the damaged region of the light emitting unit will have a high ratio when the size of the light emitting unit is reduced, which makes the phenomenon of centralization of light more severe, thus resulting in non-uniform light and less light output. In some embodiments, in order to make the light emitted from the light emitting unit 130 uniform, the light adjusting layer 140 is disposed on the light emitting unit 130 for adjusting an optical path of the emitting light (i.e., the light emitted from the light emitting unit 130 outputs from the lighting device 100 after passing through the light adjusting layer 140). In some embodiments of the present disclosure, the disposition and the design of the light adjusting layer 140 can result in more uniform light and effective light output. The light adjusting layer 140 has a refractive index different from a refractive index of the uppermost layer of the light emitting unit 130 (e.g. the second semiconductor layer 136). For example, the emitting light may be scattered through the light adjusting layer 140, but not limited thereto. In some embodiments, the light adjusting layer 140 may include an inorganic insulating material. For example, the inorganic insulating material may include silicon nitride, silicon oxide, aluminum oxide, titanium oxide, or a combination thereof, but not limited thereto. In another embodiment, the light adjusting layer 140 may include an organic insulating material. Moreover, the light adjusting layer 140 may be a single-layer structure or a multi-layer structure, wherein the multi-layer structure may include a plurality of inorganic insulating layers, a plurality of organic insulating layers, or a combination of at least one inorganic insulating layer and at least one organic insulating layer.

In accordance with the present invention, as shown in FIG. 1 and FIG. 2, the light adjusting layer 140 includes a first portion 142 and a second portion 144. The second portion 144 is defined as the portion not covering the light output surface 130s, and the first portion 142 is defined as the portion excluding the second portion 144. In detail, the first portion 142 can cover the light output surface 130s of the light emitting unit 130. In accordance with the present invention, the first portion 142 only partially covers the light output surface 130s. The second portion 144 is connected to the first portion 142 and does not cover the light output surface 130s of the light emitting unit 130. According to some embodiments, as shown in FIG. 1, one individual light emitting unit 130 is covered by one individual light adjusting layer 140, but not limited thereto. That is, the light adjusting layer covering one light emitting unit and the light adjusting layer covering another light emitting unit may be not continuous. In some embodiments, in a top view, a projected area (A1) of the first portion 142 may be greater than a projected area (sum of A2-1 and A2-2) of the second portion 144. In some embodiments, a ratio of the projected area (A1) of the first portion 142 to a projected area (A3) of the light output surface 130s may be greater than or equal to 1/10 and less than 1, but not limited thereto.

Furthermore, in accordance with the present invention, as shown in FIG. 1 and FIG. 2, the first portion 142 only partially covers the light output surface 130s. Since the light output surface 130s is not completely covered, the heat generated from the light emitting unit 130 may be effectively dissipated. In detail, the light output surface 130s is the surface including the outer contour of the light emitting unit 130, but excluding the part occupied by the electrodes 138-1 and 138-2 if the electrodes include metal. The light output surface 130s includes a top surface 130s1, a side surface 130s2 and a bottom surface 130s3. As shown in FIG. 2, the first portion 142 of the light adjusting layer 140 only covers a part of the top surface 130s1 and a part of the side surface 130s2 of the light output surface 130s, and the first portion 142 may not cover the bottom surface 130s3 of the light output surface 130s. In detail, in a top view of FIG. 2, the light adjusting layer 140 extends along a first direction D1, and the first portion 142 and the second portion 144 are connected along the first direction D1. The first portion 142 only partially overlaps the light emitting unit 130, and a part of the light emitting unit 130 (labeled as 130n) is not overlapped by the first portion 142.

In addition, according to a variant of the first example not forming part of the present invention, FIG. 3 is a schematic diagram showing a top view of the light emitting unit and the light adjusting layer of FIG. 1. As shown in FIG. 1 and FIG. 3, the first portion 142 of the light adjusting layer 140 can cover entire part of the top surface 130s1, and entire part of the side surface 130s2 of the light output surface 130s. In detail, in a top view of FIG. 3, the first portion 142 can completely overlap the light emitting unit 130, and the second portion 144 can extend along the first direction D1 and a second direction D2 and surround the first portion 142. The first direction D1 and the second direction D2 can be perpendicular. In addition, according to variant of the first example not forming part of the present invention, FIG. 4 is a schematic diagram showing a top view of the light emitting unit and the light adjusting layer of FIG. 1. As shown in FIG. 1 and FIG. 4, the first portion 142 of the light adjusting layer 140 can cover entire part of the top surface 130s1, and a part of the side surface 130s2 of the light output surface 130s. In detail, in a top view of FIG. 4, the first portion 142 can completely overlap the light emitting unit 130, and the second portion 144 is only present in the first direction D1, but not present in the second direction D2. Note that the examples shown in FIG. 3 and FIG. 4 are not forming part of the present invention.

On the other hand, a part of the emitted light may be adjusted and pass through the second portion 144 of the light adjusting layer 140, such that the second portion 144 may make the view angle wider. According to some embodiments, a ratio of the projected area (sum of A2-1 and A2-2) of the second portion 144 to the projected area (A3) of the light output surface 130s may be greater than 0 and less than or equal to 1/2. According to some embodiments, in a top view, a minimum distance L between a point of the second portion 144 farthest from the light output surface 130s and the light output surface 130s may range from 3 µm to 100 µm, but not limited thereto. This area ratio and this minimum distance L are related to a thickness of the light emitting unit 130.

Particularly, the direction of wide view angle is related to the top-view shape of the light adjusting layer 140 and the disposition of the second portion 144 of light adjusting layer 140. The light adjusting layer 140 may be designed based on requirements, and some examples are described below.

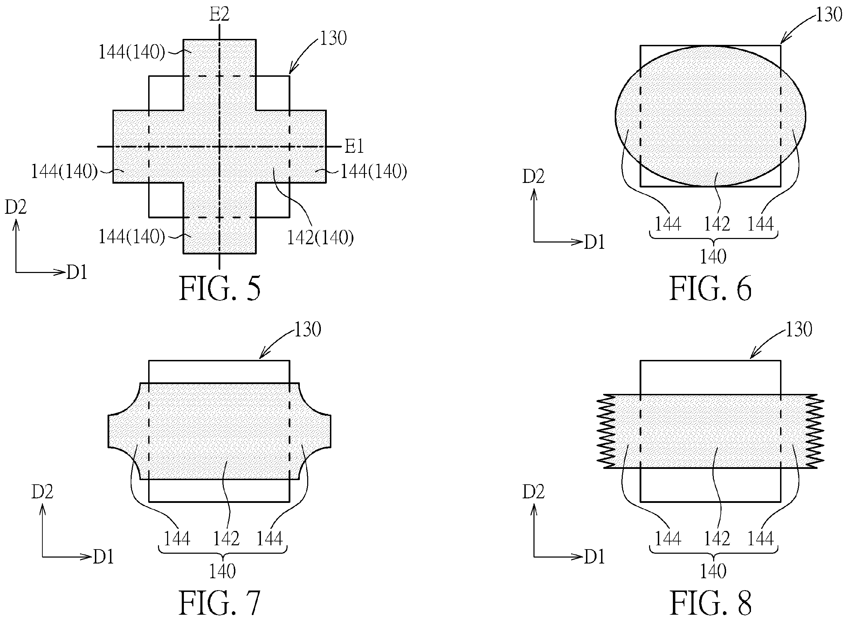

In this first example shown in FIG. 2, since the top-view shape of the light adjusting layer 140 is a rectangular with an extending line parallel to the direction D1, and the second portion 144 includes two parts disposed on the left side and the right side of the light emitting unit 130, the right view angle and the left view angle are wider. In an variant example not forming part of the present invention (although not shown), the top-view shape of the light adjusting layer 140 can be a rectangular similar to the shape as shown in FIG. 2, but arranged in an inclined manner, that is, arranged with the extending line E1 inclined with respect to the direction D1. In another variant example not forming part of the present invention, shown in FIG. 5, the top-view shape of the light adjusting layer 140 is a cruciform shape, and the second portion 144 includes four parts disposed on the upper, left, lower and right sides of the light emitting unit 130, such that these four view angles are wider. In another variant example not forming part of the present invention (although not shown), the top-view shape of the light adjusting layer 140 can be a cruciform shape similar to the shape as shown in FIG. 5, but arranged in an inclined manner, that is, arranged with the extending line E1 inclined with respect to the direction D1 and the extending line E2 inclined with respect to the direction D2. That is, the top view shape of the light adjusting layer 140 can be x-shape. The second portion 144 includes four parts disposed on the upper-left, upper-right, lower-left and lower-right sides of the light emitting unit 130, such that these four view angles are wider. In another variant example not forming part of the present invention, shown in FIG. 6, the top-view shape of the light adjusting layer 140 is an ellipse, and the length of the minor axis of the ellipse is equal to the dimension of the light emitting unit 130. In another variant example not forming part of the present invention, the top-view shape of the first portion 142 of the light adjusting layer 140 may be a rectangular, and the top-view shape of the second portion 144 of the light adjusting layer 140 may have a curved edge. For example, in FIG. 7, the second portion 144 includes two parts respectively having two curved edges, and the width of the first portion 142 is greater than the width of the second portion 144. In accordance with the present invention, an edge of the light adjusting layer 140 is zigzag. For example, in FIG. 8, an edge of the second portion 144 is zigzag. Moreover, in accordance with the present invention, the second portion 144 includes at least two parts disposed oppositely relative to the first portion 142; for instance, in FIG. 2, the two parts of the second portion 144 are disposed on the left side and the right side of the first portion 142, but not limited thereto. In accordance with the present invention, the top-view shape of the light adjusting layer 140 is asymmetric.

In addition, as shown in FIG. 1, the first portion 142 includes a first top surface 142t away from the substrate 110, and a first bottom surface 142b opposite to the first top surface 142t. The second portion 144 includes a second top surface 144t away from the substrate 110, and a second bottom surface 144b opposite to the second top surface 144t. **In** some embodiments, the first bottom surface 142b may be in contact with the light output surface 130s, but not limited thereto. Specifically, in some embodiments, a roughness of the first top surface 142t may be greater than a roughness of the second top surface 144t. **In** some embodiments, a roughness of the first top surface 142t may be less than a roughness of the first bottom surface 142b. By means of the roughness design, the scattering effect of the light adjusting layer 140 may be enhanced, so as to make the emitted light more uniform. Note that the roughness of the surface of this embodiment is defined by a height difference between two specific points of the surface within a sampling length range. For example, in a sampling length of 30µm, the roughness of one surface can be defined by a height difference between a high peak and a low valley, but not limited thereto. The definition of the roughness of the layer may be any suitable definition.

Furthermore, a thickness of the light adjusting layer 140 and a thickness of the light emitting unit 130 can be designed according to optical consideration. Specifically, if the thickness of the light adjusting layer 140 is too thick, the emitted light may be absorbed much by the light adjusting layer 140; if the thickness of the light adjusting layer 140 is too thin, the uniform effect of the light adjusting layer 140 is not well. **In** some embodiments, a ratio of the thickness of the light adjusting layer 140 to the total thickness of the first semiconductor layer 132, the light emitting layer 134 and the second semiconductor layer 136 (the thickness of the light emitting unit 130 excluding the two electrodes) may be greater than or equal to 0.006 and less than or equal to 0.16. In some embodiments, the thickness of the light adjusting layer 140 may be greater than or equal to 0.05µm and less than or equal to 0.5µm. **In** some embodiments, the total thickness of the first semiconductor layer 132, the light emitting layer 134 and the second semiconductor layer 136 (the thickness of the light emitting unit 130 excluding the two electrodes) may be greater than or equal to 3µm and less than or equal to 8µm, but not limited thereto.

Also, the lighting device 100 may further include other suitable elements or layers based on requirements. As shown in FIG. 1, the lighting device 100 of this embodiment may optionally include a cover layer CL disposed on the light emitting unit 130 for protecting the light emitting unit 130. The cover layer CL may be a passivation layer and include an insulating material, and the cover layer CL may be formed by coating, but not limited thereto. As shown in FIG. 1, the lighting device 100 of this embodiment may optionally include an adhesive layer AL disposed between the light emitting unit 130 and the circuit layer 120 for reinforcing the fixation of the light emitting unit 130, but not limited thereto. In another embodiment, the lighting device 100 may optionally include such as a black matrix (BM), a pixel define layer (PDL), a polarizer, an encapsulation layer and/or medium layer. The medium layer can be a liquid crystal layer or other suitable medium materials.

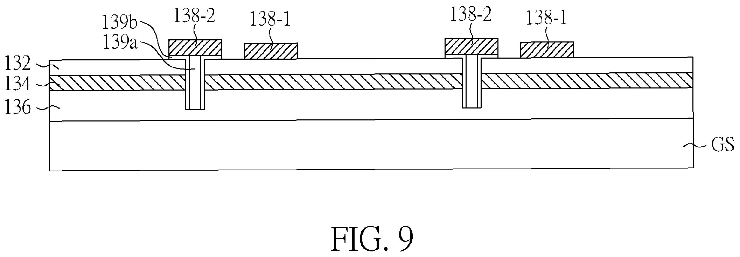

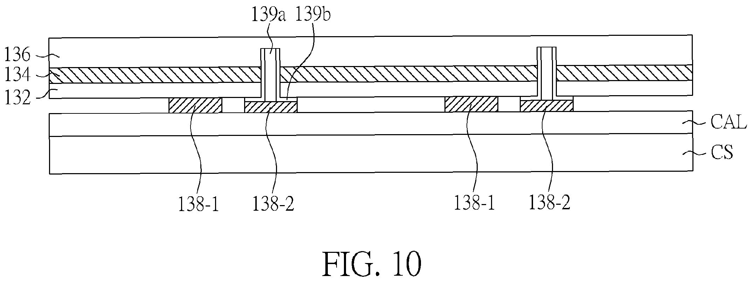

Referring to FIG. 9 to FIG. 14, FIG. 9 to FIG. 14 are schematic diagrams respectively showing a cross-sectional view of a processing state during a method for manufacturing the lighting device according to the first example. As an example, the following describes the method for manufacturing the lighting device 100 shown in FIG. 1 and FIG. 2, but not limited thereto. The method for manufacturing the lighting device 100 may be correspondingly adjusted according to the structure of the lighting device 100. As shown in FIG. 9, a growth substrate GS may be provided firstly. Then, the layers and the elements included in the light emitting unit 130 may be formed. Specifically, in this example, the second semiconductor layer 136, the light emitting layer 134 and the first semiconductor layer 132 are formed in sequence, wherein the first semiconductor layer 132 and the second semiconductor layer 136 may be formed by such as an epitaxial growth process or other suitable manufacturing process, but not limited thereto. Moreover, in another example, the buffer layer (not shown in figures) may be formed between the second semiconductor layer 136 and the growth substrate GS. Next, the first electrode 138-1 and the second electrode 138-2 may be formed, and the inner insulator 139b and the inner connecting component 139a may be optionally formed. As shown in FIG. 10, the manufacturing method uses a lift off process (e.g. laser lift off process) for transferring the layers and the elements included in the light emitting unit 130 from the growth substrate GS to a carrier substrate CS, and an adhesive layer CAL can be used to adhere the layers and the elements included in the light emitting unit 130 to the carrier substrate CS. Note that the lift off process may cause the top surface of the light emitting unit 130 (e.g. the surface of the second semiconductor layer 136) to be roughened.

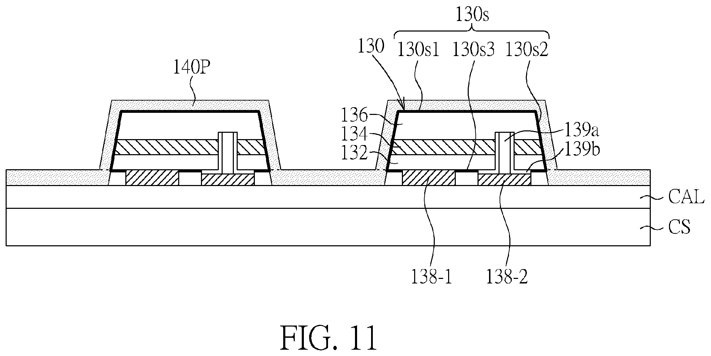

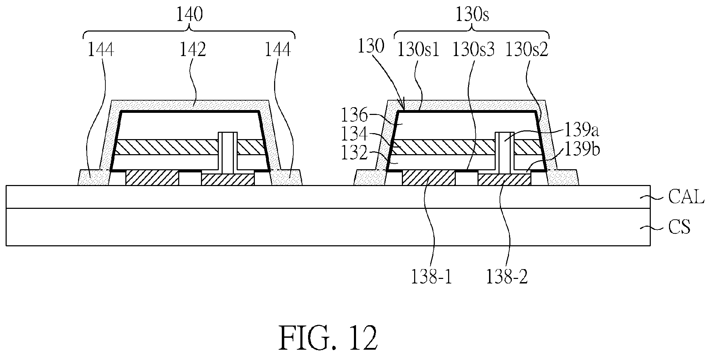

As shown in FIG. 11, the layers (e.g. the second semiconductor layer 136, the light emitting layer 134 and the first semiconductor layer 132) can be patterned, for example by photolithography technology, to form the light emitting unit 130. The photolithography technology can include a dry etching process, a wet etching process or a combination thereof. Note that the etching process may damage the light emitting unit 130 with some extent. Then, a preliminary light adjusting layer 140P is formed on the light emitting unit 130, and the preliminary light adjusting layer 140P may be formed by a suitable deposition process or any suitable forming process. In this example, the preliminary light adjusting layer 140P may completely cover the light emitting unit 130, but not limited thereto. Next, as shown in FIG. 12, the preliminary light adjusting layer 140P can be patterned to form a light adjusting layer 140. Thus, as shown in FIG. 12, the carrier substrate CS supports the light emitting unit 130 and the light adjusting layer 140 disposed on the light emitting unit 130. The light adjusting layer 140 can partially or completely cover the light emitting surface, as mentioned above. Also, in a top view, the light adjusting layer 140 can be designed to be the above-mentioned shape.

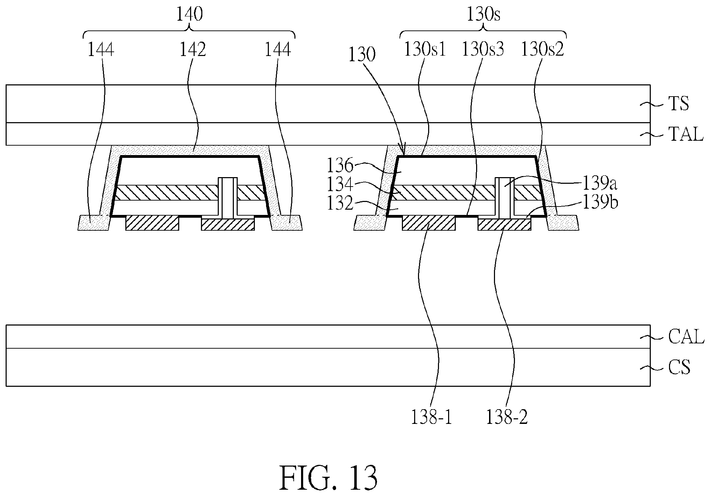

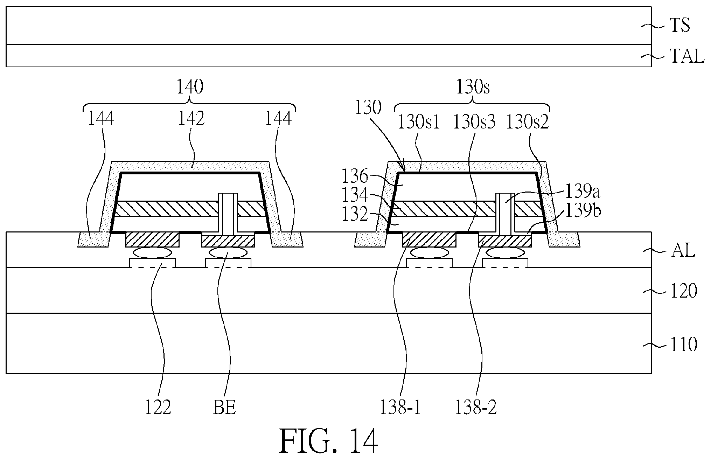

As shown in FIG. 13 and FIG. 14, a transferring process for transferring the light emitting unit 130 and the light adjusting layer 140 is performed, wherein the light emitting unit 130 and the light adjusting layer 140 are transferred from the carrier substrate CS to a substrate 110. The circuit layer 120 can be formed on the substrate 110. Specifically, in FIG. 13, a transferring substrate TS and a transferring adhesive layer TAL disposed on the transferring substrate TS is provided. Then, the transferring adhesive layer TAL may adhere to the light adjusting layer 140, so as to make the light adjusting layer 140 and the light emitting unit 130 leave from the carrier substrate CS. Then, in FIG. 14, the transferring process makes the light emitting unit 130 be bonded with at least one of the bonding pads 122 on the substrate 110 for electrical connection and fixation, and the light adjusting layer 140 and the light emitting unit 130 leave from the transferring substrate TS. The transferring process of the present disclosure is not limited thereto, and other suitable transferring processes can be used. After the above processes, other suitable layers and/or components may be formed (for instance, forming the cover layer CL), so as to complete the manufacture of the lighting device 100 shown in FIG. 1.

According to some examples, since the patterning procedure for forming the light adjusting layer 140 is subjected before the transferring process, the circuit layer 120 and other layers on the substrate 110 will not be affected by such patterning procedure, such that the yield rate may be enhanced.

The lighting device and the manufacturing method thereof of the present invention are not limited to the above embodiments. Further embodiments of the present invention are described below. For ease of comparison, same components will be labeled with the same symbol in the following. The following descriptions relate the differences between each of the embodiments, and repeated parts will not be redundantly described.

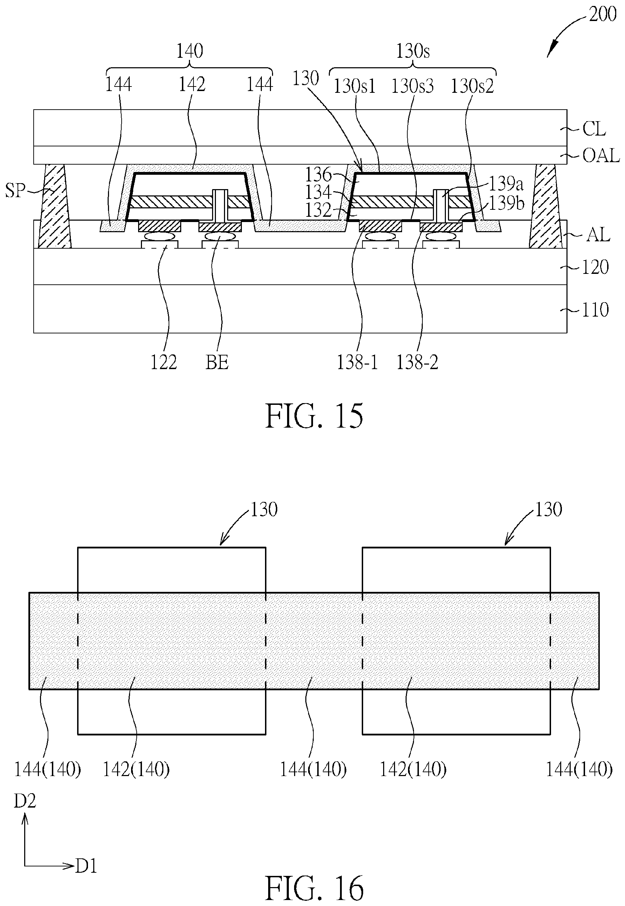

Referring to FIG. 15 and FIG. 16, FIG. 15 is a schematic diagram showing a cross-sectional view of a lighting device according to a second example not forming part of the present invention, and FIG. 16 is a schematic diagram showing a top view of light emitting units and a light adjusting layer according to a second example. As shown in FIG. 15 and FIG. 16, compared with the first embodiment, the light adjusting layer 140 of the lighting device 200 of this example continuously covers two or more light emitting units 130.

For example, the light adjusting layer 140 partially covers two light emitting units 130 in FIG. 15 and FIG. 16, but not limited thereto. The light emitting units 130 covered by the same light adjusting layer 140 may be disposed within the same sub-pixel and emit the same color, disposed within different sub-pixels and emit the same color, or disposed within different sub-pixels and emit different colors.

Moreover, in FIG. 15, the cover layer CL can be a substrate or a circuit board. When the cover layer CL is a substrate, the substrate can be hard or flexible. The material of the substrate can be glass, plastic, quartz, sapphire, polyimide, polyethylene terephthalate, but not limited thereto. In some embodiments, the cover layer CL is a substrate harder than the passivation layer to provide better protective effect. Note that, in this embodiment, the lighting device 200 may include spacers SP and an opposite adhesive layer OAL, wherein the spacers SP may separate the cover layer CL from the substrate 110, and the opposite adhesive layer OAL may be used to make the cover layer CL adhere to the spacers SP and be in contact with the light adjusting layer 140, but not limited thereto.

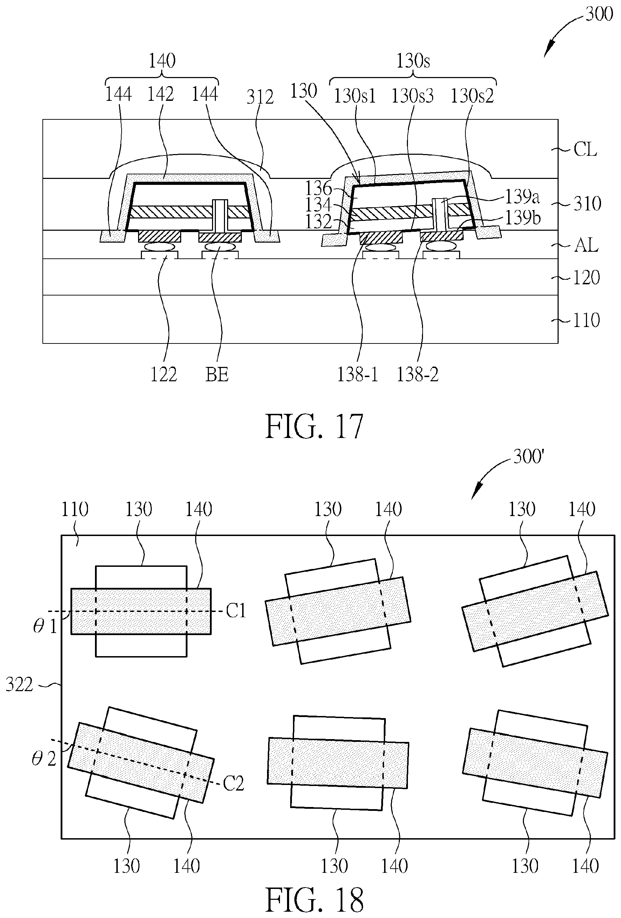

Referring to FIG. 17 and FIG. 18, FIG. 17 is a schematic diagram showing a cross-sectional view of a lighting device according to a third example not forming part of the present invention, and FIG. 18 is a schematic diagram showing a top view of a lighting device according to a variant of the third example not forming part of the present invention. As shown in FIG. 17, compared with the first example, the lighting device 300 may further include an optical layer 310 disposed on the light adjusting layer 140. According to some embodiments, the optical layer 310 can adjust the optical path of the emitting light, such that the emitted light is more uniform. In this example, the optical layer 310 also scatters the emitting light, and the optical layer 310 may include a material having scattering effect; for example, the optical layer 310 may include nanoparticles such as titanium oxide, quantum dots or other suitable particles, but not limited thereto. Furthermore, in some embodiments, the optical layer 310 may be a color filter for changing the color of the emitting light, but not limited thereto. In addition, the projected area of the light adjusting layer 140 may be less than the projected area of the optical layer 310; for example, the optical layer 310 of this embodiment may totally cover the light emitting unit 130, but not limited thereto. Also, in this example, a portion of the optical layer 310 corresponding to the light emitting unit 130 may have a convex structure 312, so as to enhance the adjusting efficiency of the optical path of the emitting light, but not limited thereto.

Moreover, the light emitting units 130 may be disposed with different angles, so as to prevent the display image from having a moiré pattern. In FIG. 17, a disposed angle between one light emitting unit 130 and the surface of the substrate 110 is different from another disposed angle between another light emitting unit 130 and the surface of the substrate 110; for instance, the disposed angle between the left light emitting unit 130 and the surface of the substrate 110 may be about 0 degrees, and the disposed angle between the right light emitting unit 130 and the surface of the substrate 110 may be greater than 0 degrees and less than 45, but not limited thereto. As shown in FIG. 18, the light emitting units 130 of the lighting device 300' of this variant embodiment may have different disposed angles related to one edge of the substrate 110 (for instance, side 322); that is to say, in a top view, a disposed angle θ1 between the side 322 and a center line C1 of one of the light emitting units 130 may be different from a disposed angle θ2 between the side 322 and a center line C2 of another one of light emitting units 130.

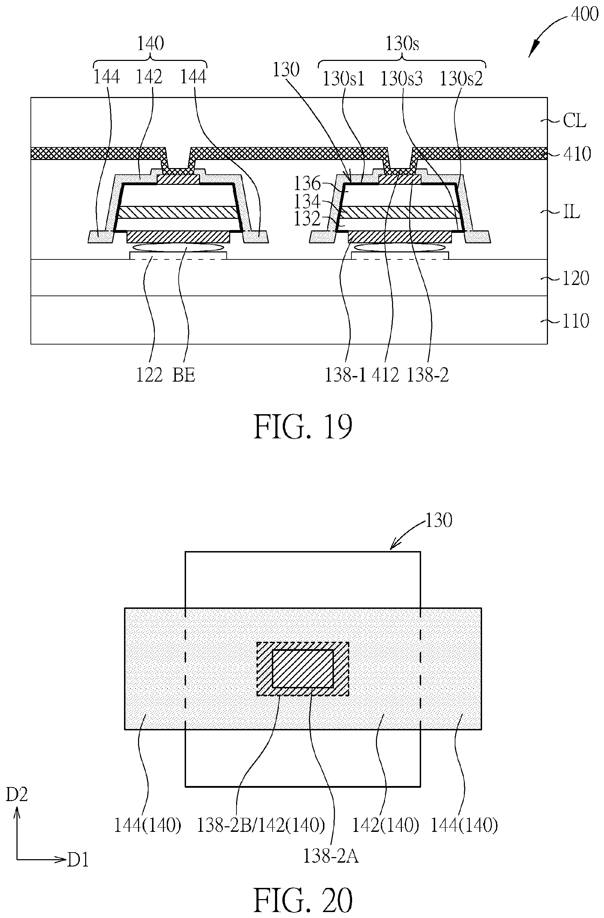

Referring to FIG. 19 and FIG. 20, FIG. 19 is a schematic diagram showing a cross-sectional view of a lighting device according to a fourth example not forming part of the present invention, and FIG. 20 is a schematic diagram showing a top view of a light emitting unit and a light adjusting layer according to the fourth example. As shown in FIG. 19 and FIG. 20, compared with the first example, the lighting device 400 of this example provides another type (vertical type) light emitting unit 130. In this example, the first electrode 138-1 is disposed between the first semiconductor layer 132 and the circuit layer 120 to serve as a bottom electrode, and the second electrode 138-2 is disposed between the second semiconductor layer 136 and the light adjusting layer 140 to serve as a top electrode. In this example, the second electrode 138-2 may be disposed at the center of the light emitting unit 130 in top-view, but not limited thereto. In another example, the second electrode 138-2 may be disposed adjacent to a side of the light emitting unit 130. Moreover, in this example, in order to make the second electrode 138-2 be electrically connected to the circuit layer 120, the lighting device 400 may further include a transparent conductive layer 410 electrically connected between the second electrode 138-2 and the circuit layer 120. In this example, the light adjusting layer 140 may partially cover the second electrode 138-2, and the transparent conductive layer 410 may include at least one electrode connecting element 412 for being in contact with the second electrode 138-2. For example, a portion of the second electrode 138-2 is exposed by the light adjusting layer 140 (shown in FIG. 19 and shown as a portion marked 138-2A in FIG. 20), and the other portion of the second electrode 138-2 is covered by the light adjusting layer 140 (shown in FIG. 19 and shown as a portion marked 138-2B/142(140) in FIG. 20), but not limited thereto. Furthermore, in this embodiment, the transparent conductive layer 410 (or the electrode connecting element 412) may include transparent conductive material, such as ITO, IZO or other suitable material. When the thickness of the light adjusting layer 140 is measured, the thickness of the light adjusting layer 140 may be referred to a thickness of a portion of the light adjusting layer 140 which does not cover the second electrode 138-2.In some embodiments, the second electrode 138-2 can include a material with heat dissipation effect, such as metal, the heat dissipation effect of the vertical type light emitting unit 130 can be enhanced.

Furthermore, in this example, the lighting device 400 may further include an insulating layer IL disposed between the circuit layer 120 and the cover layer CL, wherein the insulating layer IL may partially cover the light emitting unit 130 to protect the light emitting unit 130. In this embodiment, due to the existence of the transparent conductive layer 410, the insulating layer IL is disposed between the circuit layer 120 and the transparent conductive layer 410. In addition, the lighting device 400 may also include the adhesive layer AL disposed between the light emitting unit 130 and the circuit layer 120 for reinforcing the fixation of the light emitting unit 130 although FIG. 19 does not show, but not limited thereto.

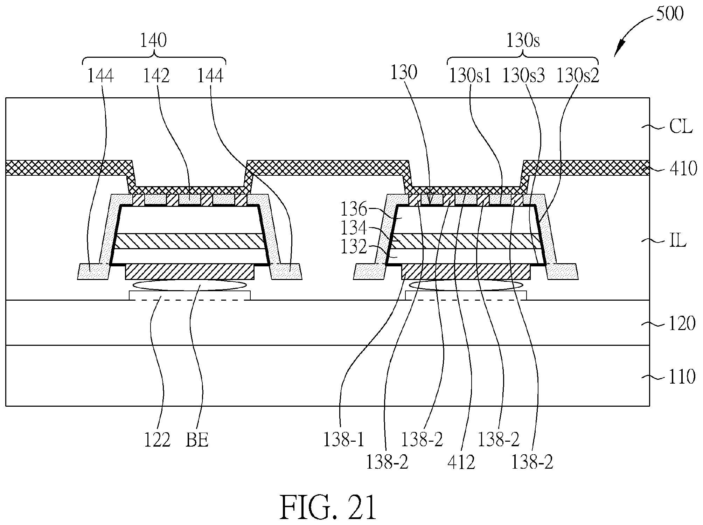

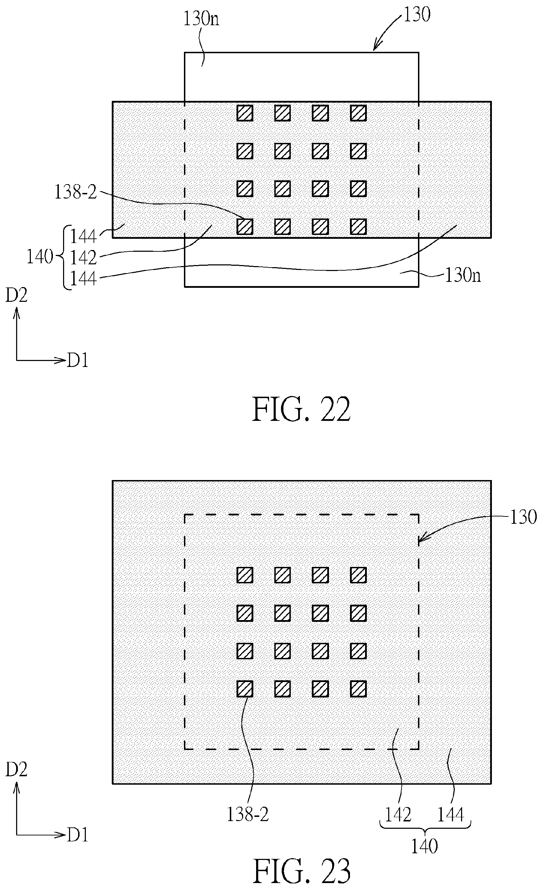

Referring to FIG. 21 and FIG. 22, FIG. 21 is a schematic diagram showing a cross-sectional view of a lighting device according to a fifth example not forming part of the present invention, and FIG. 22 is a schematic diagram showing a top view of a light emitting unit and a light adjusting layer according to the fifth example. As shown in FIG. 21 and FIG. 22, compared with the fourth example, the light emitting unit 130 of the lighting device 500 of this example may include a plurality of second electrodes 138-2 serving as the top electrodes, wherein the plurality of second electrodes 138-2 corresponding to the same light emitting unit 130 are electrically connected to each other through the electrode connecting element 412. The electrode connecting element 412 can include a transparent conductive material. The second electrodes 138-2 may be arranged in a matrix, but the arrangement of the second electrodes 138-2 is not limited thereto. In this example, the light uniformity of the light emitting unit 130 can be enhanced.

Moreover, in FIG. 21 and FIG. 22, the first portion 142 only partially covers the light output surface 130s and exposes the second electrodes 138-2. In detail, the first portion 142 of the light adjusting layer 140 can cover a part of the top surface 130s1 and a part of the side surface 130s2 of the light output surface 130s. The light adjusting layer 140 extends along the first direction D1, and the first portion 142 and the second portion 144 are connected along the first direction D1. The first portion 142 only partially overlaps the light emitting unit 130, and a part of the light emitting unit 130 (labeled as 130n) is not overlapped by the first portion 142. According to a variant of the fifth example not forming part of the present invention, , FIG. 23 is a schematic diagram showing a top view of a light emitting unit and a light adjusting layer. As shown in FIG. 21 and FIG. 23, the first portion 142 of the light adjusting layer 140 can cover the top surface 130s1 and entire part of the side surface 130s2 of the light output surface 130s, and the first portion 142 only exposes the second electrodes 138-2. The second portion 144 can extend along the first direction D1 and the second direction D2 and surround the first portion 142.

In the present invention, the above embodiments are exemplarily described, but the present invention is not limited by these embodiments. The features described in the above embodiments may be selected and combined to form another embodiment within the scope of the present invention as defined by the claims.

To summarize, according to some embodiments, owing to the design of the light adjusting layer, the light emitted from the light emitting unit can be uniform.

## Claims

1. A lighting device (100, 200, 300, 400, 500), comprising:
a substrate (110); and
a light emitting unit (130) disposed on the substrate (110) and comprising a first semiconductor layer (132), a light emitting layer (134) disposed on the first semiconductor layer (132) and a second semiconductor layer (136) disposed on the light emitting layer (134), wherein the light emitting unit (130) comprises a light output surface (130s), and the light output surface (130s) comprises a top surface (130s1), a side surface (130s2) and a bottom surface (130s3); and
a light adjusting layer (140) disposed on the second semiconductor layer (136), the light adjusting layer (140) comprising a first portion (142) and a second portion (144) connected to the first portion (142), wherein the second portion (144) comprises at least two parts disposed oppositely relative to the first portion (142), a top-view shape of the light adjusting layer (140) is asymmetric, and an edge of the second portion (144) is zigzag;
wherein the first portion (142) only partially overlaps the light emitting unit (130), the second portion (144) does not cover the light output surface (130s), and the first portion (142) covers only a part of the side surface (130s2).

2. The lighting device (100, 200, 300, 400, 500) according to claim 1, wherein, in top view, a projected area (A1) of the first portion (142) is greater than a projected area (A2-1, A2-2) of the second portion (144).

3. The lighting device (100, 200, 300, 400, 500) according to any one of claim 1 to claim 2, wherein, in top view, a ratio of a projected area (A1) of the first portion (142) to a projected area (A3) of the light output surface (130s) is greater than or equal to 1/10 and less than 1.

4. The lighting device (100, 200, 300, 400, 500) according to any one of claim 1 to claim 3, wherein, in top view, a ratio of a projected area (A2-1, A2-2) of the second portion (144) to a projected area (A3) of the light output surface (130s) is greater than 0 and less than or equal to 1/2.

5. The lighting device (100, 200, 300, 400, 500) according to any one of claim 1 to claim 4, wherein the light emitting unit (130) further comprises a circuit layer (120) disposed between the substrate (110) and the first semiconductor layer (132), a first electrode (138-1) disposed between the circuit layer (120) and the first semiconductor layer (132), and a second electrode (138-2) disposed between the second semiconductor layer (136) and the light adjusting layer (140), wherein the first electrode (138-1) is electrically connected to the first semiconductor layer (132), the second electrode (138-2) is electrically connected to the second semiconductor layer (136), and
a portion of the second electrode (138-2) is exposed by the light adjusting layer (140).

6. The lighting device (100, 200, 300, 400, 500) according to claim 5, wherein the second electrode (138-2) is disposed at a center of the light emitting unit (130) in top view.

7. The lighting device (100, 200, 300, 400, 500) according to any one of claim 1 to claim 6, further comprising an optical layer (310) disposed on the light adjusting layer (140).

## Patentansprüche

1. Beleuchtungsvorrichtung (100, 200, 300, 400, 500), welche umfasst:
ein Substrat (110); und
eine auf dem Substrat (110) angeordnete Lichtemissionseinheit (130), die eine erste Halbleiterschicht (132), eine auf der ersten Halbleiterschicht (132) angeordnete Lichtemissionsschicht (134) und eine auf der Lichtemissionsschicht (134) angeordnete zweite Halbleiterschicht (136) umfasst, worin die Lichtemissionseinheit (130) eine Lichtaustrittsfläche (130s) umfasst und die Lichtaustrittsfläche (130s) eine obere Oberfläche (130s1), eine Seitenfläche (130s2) und eine untere Oberfläche (130s3) umfasst; und
eine Lichtanpassungsschicht (140), die auf der zweiten Halbleiterschicht (136) angeordnet ist, worin die Lichtanpassungsschicht (140) einen ersten Abschnitt (142) und einen mit dem ersten Abschnitt (142) verbundenen zweiten Abschnitt (144) umfasst, worin der zweite Abschnitt (144) mindestens zwei Teile umfasst, die relativ zum ersten Abschnitt (142) gegenüberliegend angeordnet sind, die Form der Lichtanpassungsschicht (140) in der Draufsicht asymmetrisch ist und eine Kante des zweiten Abschnitts (144) zickzackförmig ist;
worin der erste Abschnitt (142) die Lichtemissionseinheit (130) nur teilweise überlappt, der zweite Abschnitt (144) die Lichtaustrittsfläche (130s) nicht bedeckt und der erste Abschnitt (142) nur einen Teil der Seitenfläche (130s2) bedeckt.

2. Beleuchtungsvorrichtung (100, 200, 300, 400, 500) nach Anspruch 1, worin in der Draufsicht eine projizierte Fläche (A1) des ersten Abschnitts (142) größer ist als eine projizierte Fläche (A2-1, A2-2) des zweiten Abschnitts (144).

3. Beleuchtungsvorrichtung (100, 200, 300, 400, 500) nach einem der Ansprüche 1 bis 2, worin in der Draufsicht ein Verhältnis einer projizierten Fläche (A1) des ersten Abschnitts (142) zu einer projizierten Fläche (A3) der Lichtaustrittsfläche (130s) größer oder gleich 1/10 und kleiner als 1 ist.

4. Beleuchtungsvorrichtung (100, 200, 300, 400, 500) nach einem der Ansprüche 1 bis 3, worin in der Draufsicht ein Verhältnis einer projizierten Fläche (A2-1, A2-2) des zweiten Abschnitts (144) zu einer projizierten Fläche (A3) der Lichtaustrittsfläche (130s) größer als 0 und kleiner oder gleich 1/2 ist.

5. Beleuchtungsvorrichtung (100, 200, 300, 400, 500) gemäß einem der Ansprüche 1 bis 4, worin die Lichtemissionseinheit (130) ferner eine zwischen dem Substrat (110) und der ersten Halbleiterschicht (132) angeordnete Schaltkreisschicht (120) umfasst, eine erste Elektrode (138-1), die zwischen der Schaltkreisschicht (120) und der ersten Halbleiterschicht (132) angeordnet ist, und eine zweite Elektrode (138-2), die zwischen der zweiten Halbleiterschicht (136) und der Lichtanpassungsschicht (140) angeordnet ist, worin die erste Elektrode (138) mit der ersten Halbleiterschicht (132) elektrisch verbunden ist, die zweite Elektrode (138-2) mit der zweiten Halbleiterschicht (136) elektrisch verbunden ist und ein Abschnitt der zweiten Elektrode (138-2) durch die Lichtanpassungsschicht (140) freigelegt ist.

6. Beleuchtungsvorrichtung (100, 200, 300, 400, 500) nach Anspruch 5, worin die zweite Elektrode (138-2) in der Draufsicht in der Mitte der Lichtemissionseinheit (130) angeordnet ist.

7. Beleuchtungsvorrichtung (100, 200, 300, 400, 500) nach einem der Ansprüche 1 bis 6, welche ferner eine auf der Lichtanpassungsschicht (140) angeordnete optische Schicht (310) umfasst.

## Revendications

1. Dispositif d'éclairage (100, 200, 300, 400, 500), comprenant:
un substrat (110); et
une unité d'émission de lumière (130) disposée sur le substrat (110) et comprenant une première couche semi-conductrice (132), une couche d'émission de lumière (134) disposée sur la première couche semi-conductrice (132) et une deuxième couche semi-conductrice (136) disposée sur la couche d'émission de lumière (134), dans lequel l'unité d'émission de lumière (130) comprend une surface de sortie de lumière (130s), et ladite surface de sortie de lumière (130s) comprend une surface supérieure (130s1), une surface latérale (130s2) et une surface inférieure (130s3); et
une couche de réglage de la lumière (140) disposée sur la deuxième couche semi-conductrice (136), la couche de réglage de la lumière (140) comprenant une première partie (142) et une deuxième partie (144) reliée à la première partie (142), dans laquelle la deuxième partie (144) comprend au moins deux éléments disposés de manière opposée par rapport à la première partie (142), la forme vue de dessus de la couche de réglage de la lumière (140) est asymétrique, et un bord de la deuxième partie (144) est en zigzag;
dans lequel la première partie (142) ne recouvrant que partiellement l'unité d'émission de lumière (130), la deuxième partie (144) ne recouvrant pas la surface de sortie de lumière (130s), et la première partie (142) ne recouvrant qu'une partie de la surface latérale (130s2).

2. Dispositif d'éclairage (100, 200, 300, 400, 500) selon la revendication 1, dans lequel, en vue de dessus, une aire projetée (A1) de la première partie (142) est supérieure à une aire projetée (A2-1, A2-2) de la deuxième partie (144).

3. Dispositif d'éclairage (100, 200, 300, 400, 500) selon l'une quelconque des revendications 1 à 2, dans lequel, en vue de dessus, le rapport entre une aire projetée (A1) de la première partie (142) et une aire projetée (A3) de la surface de sortie de lumière (130s) est supérieur ou égal à 1/10 et inférieur à 1.

4. Dispositif d'éclairage (100, 200, 300, 400, 500) selon l'une quelconque des revendications 1 à 3, dans lequel, en vue de dessus, le rapport entre une aire projetée (A2-1, A2-2) de la deuxième partie (144) et une aire projetée (A3) de la surface de sortie de lumière (130s) est supérieur à 0 et inférieur ou égal à 1/2.

5. Dispositif d'éclairage (100, 200, 300, 400, 500) selon l'une quelconque des revendications 1 à 4, dans lequel l'unité d'émission de lumière (130) comprend en outre une couche de circuit (120) disposée entre le substrat (110) et la première couche semi-conductrice (132), une première électrode (138-1) disposée entre la couche de circuit (120) et la première couche semi-conductrice (132), et une deuxième électrode (138-2) disposée entre la deuxième couche semi-conductrice (136) et la couche de réglage de la lumière (140), dans lequel la première électrode (138) est connectée électriquement à la première couche semi-conductrice (132), la deuxième électrode (138-2) est reliée électriquement à la deuxième couche semi-conductrice (136), et une partie de la deuxième électrode (138-2) est exposée par la couche de réglage de la lumière (140).

6. Dispositif d'éclairage (100, 200, 300, 400, 500) selon la revendication 5, dans lequel la deuxième électrode (138-2) est disposée au centre de l'unité d'émission de lumière (130) en vue de dessus.

7. Dispositif d'éclairage (100, 200, 300, 400, 500) selon l'une quelconque des revendications 1 à 6, comprenant en outre une couche optique (310) disposée sur la couche de réglage de la lumière (140).
